# EUROPEAN PATENT SPECIFICATION

(11) **EP 2 789 822 B1**
(45) Date of publication and mention of the grant of the patent: **08.06.2016**
(21) Application number: 14163084.8
(22) Date of filing: 01.04.2014
(51) Int. Cl.: F01N 5/02, F01N 13/16

(54) **Thermoelectric generator to engine exhaust manifold assembly**
Thermoelektrischer Generator in einer Abgaskrümmeranordnung
Générateur thermoélectrique pour ensemble de collecteur d'échappement de moteur

(30) Priority: 12.04.2013 US 201313861787; 24.06.2013 US 201313925199
(43) Date of publication of application: 15.10.2014
(73) Proprietor: Delphi Technologies, Inc., Troy MI 48007 (US)
(72) Inventor: Brandenburg, Scott D., Kokomo, IN Indiana 46902 (US); Eltom, Khalid M., Kokomo, IN Indiana 46901 (US); Myers, Bruce A., Kokomo, IN Indiana 46901 (US); Eesley, Gary L., Kokomo, IN Indiana 46902 (US); Moor, Bruce, Carmel, IN Indiana 46032 (US)
(74) Representative: Delphi France SAS

(56) References cited:
- DE-A1-102009 013 692
- DE-A1-102010 035 724
- FR-A1- 2 923 858
- US-A- 3 231 965

## Description

### TECHNICAL FIELD OF INVENTION

This disclosure generally relates to equipping a vehicle with a thermoelectric generator (TEG), and more particularly relates to a way of coupling thermally a TEG to an exhaust manifold of an internal combustion engine.

### BACKGROUND OF INVENTION

It has been suggested that up to two-thirds of the fuel consumed to operate an internal combustion engine to, for example, propel an automobile is dissipated as waste heat into the atmosphere. It has also been suggested to equip an internal combustion engine with a thermoelectric generator (TEG) to convert some of this waste heat into electricity. TEG's are known devices that generate electricity when coupled thermally to objects that are at different temperatures. In general, the greater the temperature difference between the 'hot' side and the 'cold' side of a TEG, the greater the electrical power that can be produced. It has also been recognized that the greater the thermal conductivity (i.e. less thermal resistance) between an object and a TEG, the greater the electrical power that can be produced. FR2923858 discloses another prior art device.

### SUMMARY OF THE INVENTION

In accordance with one embodiment, an assembly for coupling thermally a thermoelectric generator (TEG) to an exhaust manifold of an internal combustion engine is provided. The assembly includes a first heat exchanger, a first dielectric layer, a first conductor layer, and a first paste layer. The first heat exchanger is configured to couple thermally exhaust gas of an internal combustion engine within the first heat exchanger to an outer surface of the first heat exchanger. The outer surface is formed of stainless steel. The first dielectric layer overlays a portion of the outer surface of the first heat exchanger. The first dielectric layer formed by firing a thick-film dielectric material onto the stainless steel of the first heat exchanger. The first conductor layer overlays the first dielectric layer. The first conductor layer formed by firing a conductive thick-film onto the first dielectric layer. The TEG defines a first contact suitable to be coupled electrically to the first conductor layer. The first paste layer of silver (Ag) based sintering paste interposed between the first conductor layer and the first contact of the TEG. The first contact is sintered to the first conductor layer when the assembly is suitably arranged and suitably heated.

In another embodiment, the assembly includes a second heat exchanger, a second dielectric layer, a second conductor layer, and a second paste layer. The second heat exchanger is configured to couple thermally coolant within the second heat exchanger to an outer surface of the second heat exchanger. The outer surface is formed of stainless steel. The second dielectric layer overlays a portion of the outer surface of the second heat exchanger. The second dielectric layer is formed by firing a thick-film dielectric material onto the stainless steel of the second heat exchanger. The second conductor layer overlays the second dielectric layer. The second conductor layer is formed by firing a conductive thick-film onto the second dielectric layer. The second paste layer of silver (Ag) based sintering paste is interposed between the second conductor layer and a second contact of the TEG. The second contact is sintered to the second conductor layer when the assembly is suitably arranged and suitably heated.

In another embodiment, heat from the exhaust gas is communicated thermally through the TEG to the coolant.

In another embodiment, heat from the exhaust gas is communicated thermally through the TEG to a heat sink.

In another embodiment, the assembly further comprises a second heat exchanger configured to couple thermally coolant within the second heat exchanger to an outer surface of the second heat exchanger, wherein the outer surface is formed of stainless steel. It further comprises a sliding layer overlaying a portion of the outer surface of the second heat exchanger. The sliding layer is formed of material suitable to allow relative motion relative to the second heat exchanger. It further comprises an intermediate substrate in thermal contact with the sliding layer opposite the second heat exchanger. The intermediate layer formed of stainless steel. It further comprises a second dielectric layer. The second dielectric layer is formed by firing a thick-film dielectric material onto the intermediate substrate. It further comprises a second conductor layer overlaying the second dielectric layer. The second conductor layer is formed by firing a conductive thick-film onto the second dielectric layer. It further comprises a second paste layer of silver based sintering paste interposed between the second conductor layer and a second contact of the TEG, wherein the second contact is sintered to the second conductor layer when the assembly is suitably arranged and suitably heated.

Further features and advantages will appear more clearly on a reading of the following detailed description of the preferred embodiment, which is given by way of non-limiting example only and with reference to the accompanying drawings.

### BRIEF DESCRIPTION OF DRAWINGS

The present invention will now be described, by way of example with reference to the accompanying drawings, in which:
Fig. 1 is a perspective view of a heat exchanger assembly in accordance with one embodiment;
Fig. 2 is a sectional side view of the heat exchanger assembly of Fig. 1 in accordance with one embodiment; and
Fig. 3 is a sectional side view of the heat exchanger assembly of Fig. 1 in accordance with one embodiment which is not part of the invention.

### DETAILED DESCRIPTION

Waste heat of the exhaust from internal combustion engines can be converted into energy with the addition of a thermoelectric generator. Automobile exhaust reaches temperatures of about 800°C, and the temperature difference relative to ambient or engine coolant may be used to generate as much or more than one thousand Watts (1000W) of electrical power. This electrical power may, for example, be used to reduce the load on an automobile's alternator, thereby improving fuel economy. Described herein is a way to improve the thermal efficiency of a packaging configuration used to couple thermally a thermoelectric device to heat from automobile engine exhaust gas.

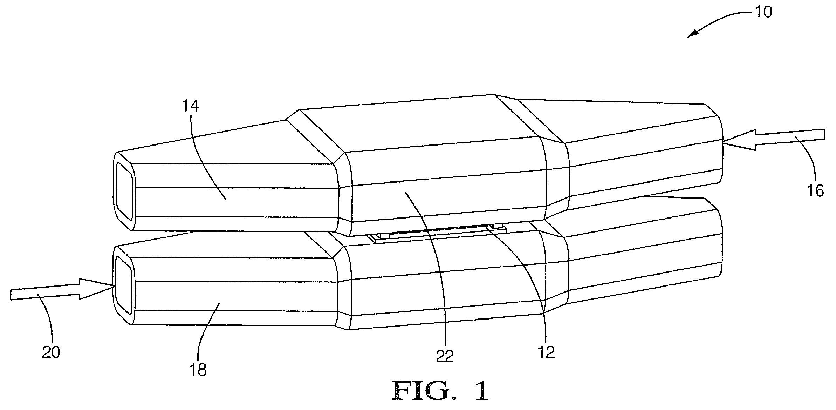

Fig. 1 illustrates a non-limiting example of an assembly 10 for coupling thermally a thermoelectric generator, hereafter the TEG 12, to an exhaust manifold, hereafter the first heat exchanger 14. Preferably, the first heat exchanger 14 is part of an exhaust system of an internal combustion engine (not shown) in a vehicle (not shown). Alternatively, the internal combustion engine may be part of a stationary power generation plant that provides mechanical energy and/or electrical energy to a location remote from a typical electrical power grid. As such, for this non-limiting example, the first heat exchanger 14 is configured to couple thermally the heat of the exhaust gas 16 that is within the first heat exchanger 14 to the TEG 12.

The TEG 12 generally generates electrical power when a temperature difference is maintained across the TEG 12. By way of example and not limitation, the temperature difference relative to the first heat exchanger 14 may be provided a second heat exchanger 18. The second heat exchanger may be part of a cooling system for an internal combustion engine. As such, for this non-limiting example, the second heat exchanger 18 is configured to couple thermally coolant 20 within the second heat exchanger 18 to the TEG 12. Alternatively, the second heat exchanger 18 may be a finned heat sink (not shown) having the fins exposed to ambient air, or coupled to a frame member of the vehicles chassis. Those skilled in the art will recognize that there are many alternatives for providing a 'cold' side to the TEG 12 to establish a temperature difference relative to the 'hot' side coupled to the first heat exchanger 14. As such, for this alternative embodiment, heat from the exhaust gas is communicated thermally through the TEG to a heat sink.

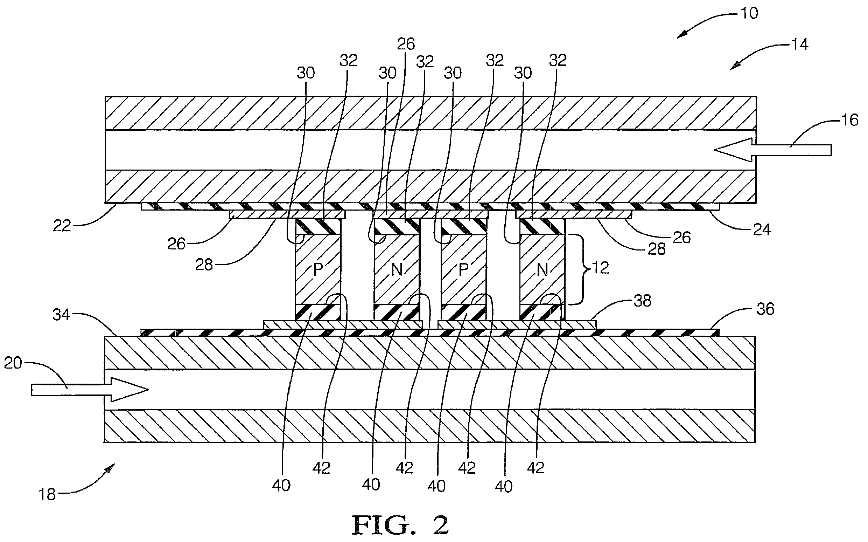

Fig. 2 further illustrates non-limiting details of the assembly 10. The TEG 12 is illustrated as having two p-type and two n-type elements, commonly known as Skutterudite junctions. It should be recognized that a TEG suitable to generate power levels in the kilowatt domain would have many more Skutterudite junctions, and those junction would likely be arranged in a two-dimensional array. The reduced number of junctions shown here and illustrated as a one-dimensional array is only for the purpose of simplifying the illustration.

As described above, the first heat exchanger 14 is generally configured to couple thermally heat from the exhaust gas 16 of an internal combustion engine (not shown) within the first heat exchanger 14 to an outer surface 22 of the first heat exchanger 14. Preferably, the outer surface 22 is formed of stainless steel, such as 409 stainless steel that is readily from several suppliers.

Using stainless steel for the outer surface 22 is particularly advantageous as it enables applying a first dielectric layer 24 to overlay a portion of the outer surface 22 of the first heat exchanger 14. Preferably, the first dielectric layer 24 is formed by firing a thick-film dielectric material such as DuPont 3500N Thick Film Dielectric onto the stainless steel forming the outer surface 22 of the first heat exchanger 14.

Prior examples of coupling thermally a thermoelectric generator to an exhaust manifold have used an alumina (Al₂O₃) substrate for a dielectric barrier between the thermoelectric generator and a metallic exhaust manifold. Alumina substrates need to be at least seven-hundred-fifty micrometers (750um or 0.75 mm) thick to be strong enough to easily process and use in such an application. Alumina has a thermal conductivity of about thirty Watts per meter-Kelvin (30 W/ (m·°K)) and so a 0.75mm thick alumina substrate can be characterized has having a thermal performance factor of 30 / 0.75 = 40.

In contrast, thick-film dielectric material such as DuPont 3500N can be applied to have a fired thickness of about thirty-seven micrometers (38um or 0.037mm). DuPont 3500N has a thermal conductivity of about two Watts per meter-Kelvin (2 W/ (m·°K)), and so the first dielectric layer 24 may be characterized has having a thermal performance factor of 2 / 0.038 = 53, about a 33% improvement in thermal performance when compared to the alumina substrate example above. In other words, using the dielectric layer for the first dielectric layer instead of the previously proposed alumina substrate decreases the heat energy lost as heat passes from the first heat exchanger 14 to the TEG 12 by 25%.

Continuing to refer to Fig. 2, the assembly 10 may include first conductor layer 26 overlaying the first dielectric layer 24. In general, the first conductor layer 26 is arranged to interconnect the various elements that make up the TEG, and provide a contact pad 28 for making electrical connections (not shown) to the assembly 10. A suitable material for the first conductor layer is thick film silver ink available from DuPont and other suppliers. Various ways to make electrical connections to the contact pad 28 will be recognized by those skilled in the art. For example, a metallic wire, foil, or ribbon (none shown) may be soldered or brazed to the contact pad 28 so electrical energy generated by the TEG 12 can be conveyed to other locations outside of the assembly.

The first conductor layer 26 is preferably formed by firing a conductive thick-film onto the first dielectric layer 24. The first conductor layer 26 may be co-fired with the first dielectric layer 24 as part of a single firing operation, or the first conductor layer 26 may be fired onto the first dielectric layer 24 subsequent to firing the first dielectric layer as part of a sequential firing operation.

The TEG 12 is generally configured to define a first contact 30 suitable to be coupled electrically to the first conductor layer 26. Electrical coupling of the first contact 30 to the first conductor layer 26 is preferably provided by a first paste layer 32 formed of silver (Ag) based sintering paste interposed between the first conductor layer 26 and the first contact 30 of the TEG 12. A suitable material for the first paste layer 32 is LOCTITE ABLESTIK SSP-2000 silver sintering paste, preferably applied using known screen printing method to a thickness of one-hundred micrometers (100 um) which would have a thickness of fifty micrometers (50 um) after drying. Accordingly, the first contact 30 preferably has a surface layer suitable for silver sintering such as silver. In general, the first contact 30 is sintered to the first conductor layer 26 by the first paste layer 32 when the assembly 10 is suitably arranged and suitably heated. Suitably arranging the assembly 10 may include arranging the various layers as illustrated in Figs. 1 and 2, to form stack, and optionally applying a force to the stack. Suitably heating the assembly may include heating the assembly to a temperature of three-hundred degrees Celsius (300°C) for five minutes (5 min.) and then cooling the assembly 10 to room temperature.

Preferably, the assembly 10 is stress balanced about the TEG 12, and so the various layers and interfaces described above may be mirror imaged on the other side of the TEG 12 opposite the first contact 30. Accordingly, an outer surface 34 of the second heat exchanger 18 is preferably formed of stainless steel, preferably the same alloy used to form the outer surface 22 of the first heat exchanger 14. The assembly 10 may also include a second dielectric layer 36 overlaying a portion of the outer surface 34 of the second heat exchanger 18. Like the first dielectric layer 24, the second dielectric layer 36 is preferably formed by firing a thick-film dielectric material (e.g. DuPont 3500N) onto the stainless steel of the second heat exchanger 18.

The assembly 10 may also include a second conductor layer 38 overlaying the second dielectric layer 36. The second conductor layer 38 is preferably formed the same material used for the first conductor layer 26 and processed in the same manner as the first conductor layer 26 by firing the conductive thick-film onto the second dielectric layer 36. Similarly, the assembly 10 may include a second paste layer 40 of silver (Ag) based sintering paste interposed between the second conductor layer and a second contact 42 of the TEG, wherein the second contact 42 is sintered to the second conductor layer 38 when the assembly is suitably arranged and suitably heated. As such, the assembly 10 described herein is configured so heat from the exhaust gas 16 is communicated thermally through the TEG 12 to the coolant 20. Alternatively, if the second heat exchanger 18 is a heat sink as suggested above, heat from the exhaust gas 16 is communicated thermally through the TEG 12 to the heat sink (not shown).

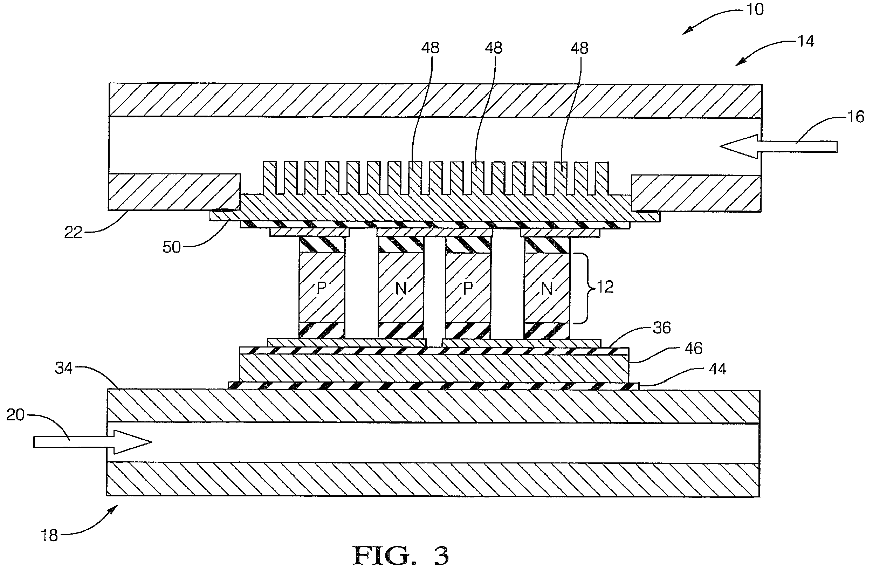

Fig. 3 illustrates a non-limiting example of the assembly 10 which is not part of the invention that adds a sliding layer and an intermediate substrate 46 to the thermal path between the outer surface 34 of the second heat exchanger 18, and the second dielectric layer 36. The sliding layer 44 allows relative motion between the TEG 12 and the second heat exchanger 18 so unequal expansion of the first heat exchanger 14 and the second heat exchanger 18 does not cause stress that could damage the TEG 12. In this non-limiting example, the intermediate substrate 46 may be attached to the TEG 12 using the techniques described above, and then the sliding layer 44 may be formed by applying thermal grease or other suitable material to the outer surface 34.

Fig. 3 show another alternative feature of the assembly 10 which is not part of the invention, that being that fins 48 or other similar surface-area increasing features may be added to improve heat transfer from the exhaust gas 16 to the TEG 12. By way of example and not limitation, the fins 48 may be part of a heat sink 50 that is, for example, first assembled to the TEG 12 and then welded to the outer surface 22 of the first heat exchanger 14.

Accordingly, an assembly 10 for coupling thermally a thermoelectric generator (TEG) to an exhaust manifold (e.g. the first heat exchanger 14) of an internal combustion engine is provided. Using screen printed thick film to form a dielectric layer on the first heat exchanger improves thermal efficiency over prior configurations that use an alumina substrate as a dielectric barrier. Such an arrangement will have improved reliability as the materials have been selected to have matched coefficients of thermal expansion (CTE) of about ten to twelve parts per million per degree Celsius (10-12 ppm/°C). By applying dielectric material directly to the heat exchangers, the thermal interface materials typically present are eliminated.

## Claims

1. An assembly (10) for coupling thermally a thermoelectric generator (TEG (12)) to an exhaust manifold of an internal combustion engine, said assembly (10) comprising:
a first heat exchanger (14) configured to couple thermally exhaust gas (16) of an internal combustion engine within the first heat exchanger (14) to an outer surface (22) of the first heat exchanger (14), wherein the outer surface (22) is formed of stainless steel,
a TEG (12) that defines a first contact (30) suitable to be coupled electrically to a first conductor layer (26);
**characterized in that**
a first dielectric layer (24) overlaying a portion of the outer surface (22) of the first heat exchanger (14), said first dielectric layer (24) formed by firing a thick-film dielectric material onto the stainless steel of the first heat exchanger (14);
a first conductor layer (26) overlaying the first dielectric layer (24), said first conductor layer (26) formed by firing a conductive thick-film onto the first dielectric layer (24);
a first paste layer (32) of silver (Ag) based sintering paste interposed between the first conductor layer (26) and the first contact (30) of the TEG (12), wherein the first contact (30) is sintered to the first conductor layer (26) when the assembly (10) is suitably arranged and suitably heated.

2. Assembly (10) in accordance with claim 1, wherein assembly (10) further comprises
a second heat exchanger (18) configured to couple thermally coolant (20) within the second heat exchanger (18) to an outer surface (22) of the second heat exchanger (18), wherein the outer surface (22) is formed of stainless steel;
a second dielectric layer (36) overlaying a portion of the outer surface (22) of the second heat exchanger (18);
a second conductor layer (38) overlaying the second dielectric layer (36), said second conductor layer (38) formed by firing a conductive thick-film onto the second dielectric layer (36);
a second paste layer (40) of silver (Ag) based sintering paste interposed between the second conductor layer (38) and a second contact (42) of the TEG (12), wherein the second contact (42) is sintered to the second conductor layer (38) when the assembly (10) is suitably arranged and suitably heated.

3. Assembly (10) in accordance with claim 2, wherein said second dielectric layer (36) is formed by firing a thick-film dielectric material onto the stainless steel of the second heat exchanger (18).

4. Assembly (10) in accordance with claim 2, wherein heat from the exhaust gas (16) is communicated thermally through the TEG (12) to the coolant (20).

5. Assembly (10) according to claim 2, wherein assembly (10) further comprises
a sliding layer (44) overlaying a portion of the outer surface (22) of the second heat exchanger (18), said sliding layer (44) formed of material suitable to allow relative motion relative to the second heat exchanger (18);
an intermediate substrate (46) in thermal contact with the sliding layer (44) opposite the second heat exchanger (18), said intermediate layer formed of stainless steel;
the second dielectric layer (36) is formed by firing a thick-film dielectric material onto the intermediate substrate (46).

## Patentansprüche

1. Anordnung (10) zum thermischen Koppeln eines thermoelektrischen Generators (TEG - thermoelectric generator (12)) mit einem Abgassammler eines Verbrennungsmotors, wobei die Anordnung (10) aufweist:
einen ersten Wärmetauscher (14), der konfiguriert ist zum thermischen Koppeln von Abgas (16) eines Verbrennungsmotors in dem ersten Wärmetauscher (14) mit einer Außenfläche (22) des ersten Wärmetauschers (14), wobei die Außenfläche (22) aus rostfreiem Stahl gebildet ist,
einen TEG (12), der einen ersten Kontakt (30) definiert, der geeignet ist, elektrisch mit einer ersten Leiterschicht (26) gekoppelt zu werden;
**dadurch gekennzeichnet, dass**
eine erste dielektrische Schicht (24) über einem Teil der Außenfläche (22) des ersten Wärmetauschers (14) liegt, wobei die erste dielektrische Schicht (24) gebildet wird durch Brennen eines dielektrischen Dickschichtmaterials auf den rostfreien Stahl des ersten Wärmetauschers (14);
eine erste Leiterschicht (26) über der ersten dielektrischen Schicht (24) liegt, wobei die erste Leiterschicht (26) durch Brennen einer leitfähigen Dickschicht auf die erste dielektrische Schicht (24) gebildet wird;
eine erste Pastenschicht (32) aus Silber(Ag)-basierter Sinterpaste angeordnet zwischen der ersten Leiterschicht (26) und dem ersten Kontakt (30) des TEGs (12), wobei der erste Kontakt (30) an die erste Leiterschicht (26) gesintert wird, wenn die Anordnung (10) geeignet angeordnet und geeignet erhitzt ist.

2. Anordnung (10) gemäß Anspruch 1, wobei die Anordnung (10) weiter aufweist
einen zweiten Wärmetauscher (18), der konfiguriert ist zum thermischen Koppeln von Kühlmittel (20) in dem zweiten Wärmetauscher (18) mit einer Außenfläche (22) des zweiten Wärmetauschers (18), wobei die Außenfläche (22) aus rostfreiem Stahl gebildet ist;
eine zweite dielektrische Schicht (36), die über einem Teil der Außenfläche (22) des zweiten Wärmetauschers (18) liegt;
eine zweite Leiterschicht (38), die über der zweiten dielektrischen Schicht (36) liegt, wobei die zweite Leiterschicht (38) durch Brennen einer leitfähigen Dickschicht auf die zweite dielektrische Schicht (36) gebildet wird;
eine zweite Pastenschicht (40) aus Silber(Ag)-basierter Sinterpaste angeordnet zwischen der zweiten Leiterschicht (38) und einem zweiten Kontakt (42) des TEGs (12), wobei der zweite Kontakt (42) an die zweite Leiterschicht (38) gesintert wird, wenn die Anordnung (10) geeignet angeordnet und geeignet erhitzt ist.

3. Anordnung (10) gemäß Anspruch 2, wobei die zweite dielektrische Schicht (36) durch Brennen eines dielektrischen Dickschichtmaterials auf den rostfreien Stahl des zweiten Wärmetauschers (18) gebildet wird.

4. Anordnung (10) gemäß Anspruch 2, wobei Wärme von dem Abgas (16) thermisch durch den TEG (12) an das Kühlmittel (20) kommuniziert wird.

5. Anordnung (10) gemäß Anspruch 2, wobei die Anordnung (10) weiter aufweist
eine Gleitschicht (44), die über einem Teil der Außenfläche (22) des zweiten Wärmetauschers (18) liegt, wobei die Gleitschicht (44) aus einem Material gebildet ist, das geeignet ist, um eine relative Bewegung in Bezug auf den zweiten Wärmeaustauscher (18) zu ermöglichen;
ein Zwischensubstrat (46) in thermischem Kontakt mit der Gleitschicht (44) entgegengesetzt zu dem zweiten Wärmetauscher (18), wobei die Zwischenschicht aus rostfreiem Stahl gebildet ist;
wobei die zweite dielektrische Schicht (36) durch Brennen eines dielektrischen Dickschichtmaterials auf das Zwischensubstrat (46) gebildet wird.

## Revendications

1. Assemblage (10) pour coupler thermiquement un générateur thermoélectrique (TEG (12)) à un collecteur d'échappement d'un moteur à combustion interne, ledit assemblage (10) comprenant :
un premier échangeur de chaleur (14) configuré pour coupler thermiquement les gaz d'échappement (16) d'un moteur à combustion interne à l'intérieur du premier échangeur de chaleur (14) à une surface extérieure (22) du premier échangeur de chaleur (14), dans lequel la surface extérieure (22) est formée en acier inoxydable,
un générateur thermoélectrique TEG (12) qui définit un premier contact (30) approprié à être couplé électriquement à une première couche conductrice (26) ;
**caractérisé en ce que**
une première couche diélectrique (24) recouvre une portion de la surface extérieure (22) du premier échangeur de chaleur (14), ladite première couche diélectrique (24) étant formée par cuisson d'un matériau diélectrique en forme de film épais sur l'acier inoxydable du premier échangeur de chaleur (14) ;
une première couche conductrice (26) recouvre la première couche diélectrique (24), ladite première couche conductrice (26) étant formée par cuisson d'un film épais conducteur sur la première couche diélectrique (24) ;
une première couche pâteuse (32) d'une pâte de frittage à base d'argent (Ag) interposée entre la première couche conductrice (26) et le premier contact (30) du générateur thermoélectrique TEG (12), dans lequel le premier contact (30) est fritté sur la première couche conductrice (26) quand l'assemblage (10) est agencé de manière appropriée et chauffé de manière appropriée.

2. Assemblage (10) selon la revendication, dans lequel l'assemblage (10) comprend en outre :
un second échangeur de chaleur (18) configuré pour coupler thermiquement un réfrigérant (20) à l'intérieur du second échangeur de chaleur (18) à une surface extérieure (22) du second échangeur de chaleur (18), dans lequel la surface extérieure (22) est formée en acier inoxydable ;
une seconde couche diélectrique (36) qui recouvre une portion de la surface extérieure (22) du second échangeur de chaleur (18) ;
une seconde couche conductrice (38) qui recouvre la seconde couche diélectrique (36), ladite seconde couche conductrice (38) étant formée par cuisson d'un film épais conducteur sur la seconde couche diélectrique (36) ;
une seconde couche pâteuse (40) d'une pâte de frittage à base d'argent (Ag) interposée entre la seconde couche conductrice (38) et un second contact (42) du générateur thermoélectrique (12), dans lequel le second contact (42) est fritté sur la seconde couche conductrice (38) quand l'assemblage (10) est agencé de manière appropriée et chauffé de manière appropriée.

3. Assemblage (10) selon la revendication 2, dans lequel ladite seconde couche diélectrique (36) est formée par cuisson d'un matériau diélectrique en film épais sur l'acier inoxydable du second échangeur de chaleur (18).

4. Assemblage (10) selon la revendication 2, dans lequel la chaleur des gaz d'échappement (16) est communiquée au réfrigérant (20) thermiquement via le générateur thermoélectrique (12).

5. Assemblage (10) selon la revendication 2, ledit assemblage (10) comprenant en outre
une couche de glissement (44) qui recouvre une portion de la surface extérieure (22) du second échangeur de chaleur (18), ladite couche de glissement (44) étant formée d'un matériau approprié pour permettre un mouvement relatif par rapport au second échangeur de chaleur (18) ;
un substrat intermédiaire (46) en contact thermique avec la couche de glissement (44) à l'opposé du second échangeur de chaleur (18), ladite couche intermédiaire étant formée d'acier inoxydable ;
la seconde couche diélectrique (36) est formée par cuisson d'un matériau diélectrique en film épais sur le substrat intermédiaire (46).
